# EUROPÄISCHE PATENTSCHRIFT

(11) **EP 1 216 419 B1**
(45) Veröffentlichungstag und Bekanntmachung des Hinweises auf die Patenterteilung: **10.03.2004**
(21) Anmeldenummer: 00978936.3
(22) Anmeldetag: 18.09.2000
(51) Int. Cl.: G01R 1/067

(54) **Me spitze zur Hochfrequenzmessung**
Measuring probe for measuring high frequencies
Pointe de mesure pour mesure de hautes fréquences

(30) Priorität: 21.09.1999 DE 19945178
(43) Veröffentlichungstag der Anmeldung: 26.06.2002
(73) Patentinhaber: Rosenberger Hochfrequenztechnik GmbH & Co., 83413 Fridolfing (DE)
(72) Erfinder: WOLLITZER, Michael, 83413 Fridolfing (DE)
(74) Vertreter: Zeitler, Giselher
(86) Internationale Anmeldenummer: PCT/DE2000/003231
(87) Internationale Veröffentlichungsnummer: WO 2001/022097

(56) Entgegenhaltungen:
- US-A- 4 697 143
- US-A- 4 894 612

## Beschreibung

Die Erfindung betrifft eine Meßspitze zur Hochfrequenzmessung gemäß dem Oberbegriff des Anspruchs 1.

Zum Testen von beispielsweise auf Wafern hergestellten, elektronischen Schaltungen auf deren Funktionsfähigkeit und deren elektrischen Eigenschaften werden üblicherweise Meßspitzen verwendet, welche auf entsprechenden Kontaktstellen der zu testenden elektronischen Schaltung mechanisch aufsetzen. Derartige zu testende elektronische Schaltung erzeugen bzw. verarbeiten zunehmend auch Hochfrequenzsignale, so daß sich für die Meßspitze eine entsprechend zu beachtende impedanz ergibt. Mit anderen Worten muß die Meßspitze eine an den Kontakt mit der zu testenden elektrischen Schaltung angepaßte Impedanz aufweisen, da sich sonst bei Fehlanpassungen, wie allgemein bekannt, entsprechende Reflexionen ergeben, welche ein Meßergebnis in unerwünschter Weise beeinflussen oder eine Messung gar unmöglich machen. Auch über die Meßspitze selbst sollte sich keine Änderung der Impedanz ergeben, da auch derartige Impedanzsprünge entsprechende Reflexionsstellen erzeugen.

So ist aus der US 4 697 143 eine Meßspitze bekannt, welche zum Erzielen einer konstanten Impedanz von einem Meßkabel zu einem Kontaktpunkt eine koplanare Leiterstruktur aufweist, wobei ein Signalleiter und ein Masseleiter derart voneinander beabstandet sind, daß sich eine gewünschte, konstante Impedanz ergibt. Dies Anordnung hat jedoch den Nachteil, daß aufgrund der Verwendung eines Aluminiumoxidsubstrats eine aufwendige Abschirmung zum Vermeiden von Moden höherer Ordnung erforderlich ist. Ferner ist diese Meßspitze kompliziert, aufwendig und kostenintensiv in der Herstellung. Da wegen entsprechender Toleranzen nicht jede hergestellte Meßspitze die vorgegebenen Parameter erfüllt, ergibt sich ein hoher Ausschluß bei der Produktion, was diese Meßspitze zusätzlich verteuert. Darüber hinaus ergibt sich durch die insgesamt starre Anordnung der koplanaren Leiterstruktur mit insbesondere drei oder mehr Leitern ein Kontaktierungsproblem, da es bei den auf Wafern vorliegenden Abmessungen wegen entsprechender Toleranzen der Meßspitze, der Kontaktstellen und der mechanischen Ausrichtung der Meßspitze mechanisch nahezu unmöglich ist, daß bei Aufsetzen der Meßspitze auf die Kontaktstellen alle Leiter der koplanaren Leiterstruktur der Meßspitze genau in der Ebene der Kontaktstellen liegen. Daher kontaktieren einige Leiter ihre jeweilige Kontaktstelle besser und andere schlechter oder ggf. überhaupt nicht.

Aus der US 4 894 612 ist eine Meßspitze bekannt, bei der über eine gesamte Länge einer koplanaren Leiterstruktur ein Dielektrikum angeordnet ist. Ferner wird eine Meßspitze mit Streifenleitungen offenbart, wobei sich Enden der Streifenleitungen federnd von einem halternden Substrat abheben.

Der Erfindung liegt die Aufgabe zugrunde, eine verbesserte Meßspitze der o.g. Art zur Verfügung zu stellen, wobei eine einfache und kostengünstige Serienproduktion bei gleichzeitig guter Kontaktqualität erzielt wird.

Diese Aufgabe wird durch eine Meßspitze der o.g. Art mit den in Anspruch 1 gekennzeichneten Merkmalen gelöst. Vorteilhafte Ausgestaltungen der Erfindung sind in den jeweils abhängigen Ansprüchen angegeben.

Bei einer Meßspitze der o.g. Art ist es erfindungsgemäß vorgesehen, daß das Dielektrikum auf der koplanaren Leiterstruktur in einem mittleren Abschnitt zwischen und in Ausbreitungsrichtung beabstandet von dem koaxialkabelseitigen Ende und dem kontaktseitigen Ende wenigstens einseitig, insbesondere beidseitig, derart angeordnet ist, daß zwischen dem Dielektrikum und dem kontaktseitigen Ende jeder Leiter der koplanaren Leiterstruktur individuell frei im Raum und bzgl. des haltemden Dielektrikums federnd ausgebildet ist, wobei zwischen je zwei Leitern der koplanaren Leiterstruktur von dem koaxialkabelseitigen Ende bis zum kontaktseitigen Ende ein jeweiliger Spalt derart ausgebildet ist, daß sich vom koaxialkabelseitigen Ende bis zum kontaktseitigen Ende ein konstanter Wellenwiderstand ergibt.

Dies hat den Vorteil, daß eine kostengünstige und präzise auch in Serienfertigung herstellbare Meßspitze mit Impedanzkontrolle zur Verfügung steht, so daß sich geringe Reflextionen bei der Kontaktierung mit der planaren Struktur zu Meßzwecken ergeben. Die erfindungsgemäße Anordnung zeichnet sich durch Betriebsfrequenzen von bis zu 40 bis 60 GHz aus, wobei die Impedanz über die gesamte koplanare Leiterstruktur aufgrund der erfindungsgemäßen Ausbildung im wesentlichen dispersionsfrei, d.h. unabhängig von der Betriebsfrequenz, ist. Durch die frei federnde Anordnung der Leiter der koplanaren Leiterstruktur zwischen dem Dielektrikum und dem koaxialkabelseitigen Ende ist eine hohe Kontaktqualität zwischen allen Leitern der koplanaren Leiterstruktur und entsprechenden Kontaktstellen einer zu prüfenden Einrichtung gewährleistet, wobei die Kontaktqualität unempfindlich bzgl. eines verkippten Aufsetzens der Meßspitze auf die Kontaktstellen ist.

In einer bevorzugten Ausführungsform ist das Dielektrikum als wenigstens ein Quarzblock ausgebildet.

Zum Herstellen einer festen Verbindung zwischen der koplanaren Leiterstruktur und dem Dielektrikumblock weist dieser an einer Verbindungsseite mit der koplanaren Struktur eine sich mit letzterer im wesentlichen deckende Metallbeschichtung auf.

Zum Unterdrücken von Moden höherer Ordnung oberhalb der gewünschten Betriebsfrequenz ist das Dielektrikum an einer der koplanaren Leiterstruktur abgewandten Seite vollflächig metallisiert. Ferner ergibt sich dadurch im Bereich des Dielektrikums eine geschlossene, abgeschirmte Struktur.

Für bestimmte Anwendungen ist am koaxialkabelseitigen Ende eine planare Schaltung, insbesondere eine elektrische, elektronische bzw. aktive Schaltung, oder wenigstens ein aktives Schaltungselement angeordnet. Hierdurch liegt die zusätzliche Schaltung bzw. das zusätzliche Schaltungselement in unmittelbarer Nähe zu Kontakten zwischen der Meßspitze und einer zu testenden Schaltung am kontaktseitigen Ende der Meßspitze.

Die Erfindung wird im folgenden anhand der Zeichnung näher erläutert. Diese zeigt in:
- Fig. 1: eine erste bevorzugte Ausführungsform einer erfindungsgemäßen Meßspitze in perspektivischer Ansicht,
- Fig. 2: eine zweite bevorzugte Ausführungsform einer erfindungsgemäßen Meßspitze in perspektivischer Ansicht,
- Fig. 3: eine dritte bevorzugte Ausführungsform einer erfindungsgemäßen Meßspitze in Aufsicht,
- Fig. 4 bis Fig. 7: eine Veranschaulichung. aufeinanderfolgender Schritte eines erfindungsgemäßen Verfahrens und
- Fig. 8: einen S-Parameter-Plott einer Simulationsrechnung für eine erfin-. dungsgemäße Meßspitze.

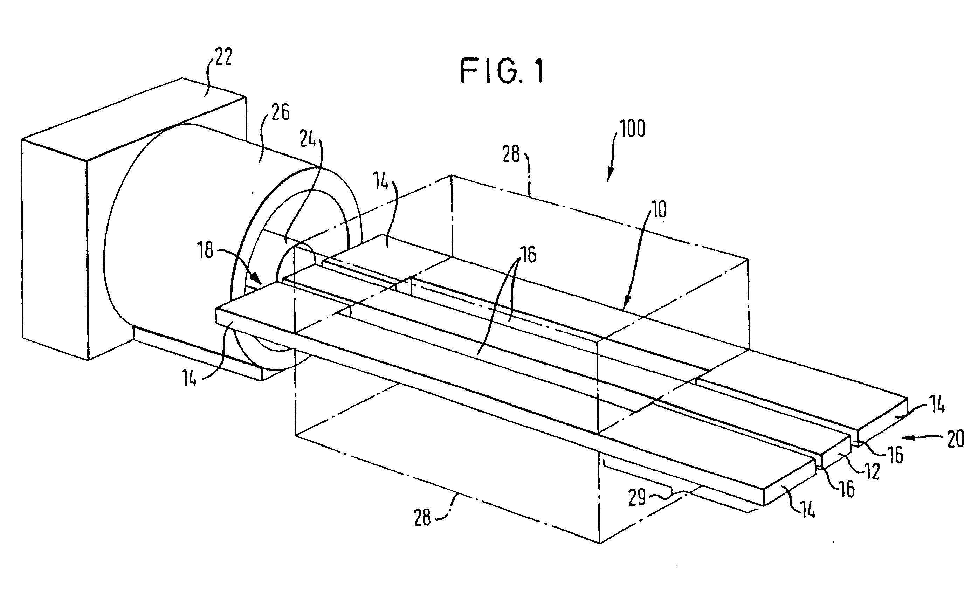

Die in Fig. 1 dargestellte, erste bevorzugte Ausführungsform einer erfindungsgemäßen Meßspitze 100 umfaßt eine koplanare Leiterstruktur 10 mit einem mittigen Signalleiter 12 und zwei koplanar benachbart zu diesem Signalleiter 12 angeordnete Masseleiter 14. Zwischen dem Signalleiter 12 und einem jeweiligen Masseleiter 14 ist ein vorbestimmter Spalt 16 ausgebildet. Die koplanare Leiterstruktur 10 erstreckt sich von einem koaxialkabelseitigen Ende 18 zu einem kontaktseitigen Ende 20, und der Spalt 16 ist über die gesamte Länge der koplanaren Leiterstruktur 10 derart ausgebildet, dass sich ein konstanter, vorbestimmter Wellenwiderstand ergibt. An dem koaxialkabelseitigen Ende 18 ist die koplanare Leiterstruktur 10 mit einem Koaxialkabel 22 verbunden, wobei der Signalleiter 12 einen Innenleiter 24 und die Masseleiter 14 einen Außenleiter 26 des Koaxialkabels kontaktieren.

In einem mittleren Abschnitt zwischen dem koaxialseitigen Ende 18 und dem kontaktseitigen Ende 20 ist beidseits der koplanaren Leiterstruktur 10 ein Dielektrikum in Form eines jeweiligen Quarzblockes 28 angeordnet. Hierbei sind die beiden Quarzblöcke 28 und die koplanare Leiterstruktur 10 in einer sandwichartigen Struktur aufeinandergelegt. Die Quarzblöcke 28 sind mit der koplanaren Leiterstruktur 10 fest verbunden und tragen jeweils an ihrer der koplanaren Leiterstruktur 10 zugewandten Seite eine Metallisierung, welche im wesentlichen der Form der koplanaren Leiterstruktur 10 im Bereich der Quarzblöcke 28 entspricht. Auf diese Weise erzielt man eine besonders gut haltende und enge Verbindung zwischen den Quarzblöcken 28 und den Leitern 12, 14 der koplanaren Leiterstruktur 10. Aufgrund der elektromagnetischen Verhältnisse mit Dielektrikum 28 ist der Spalt 16 im Bereich der Quarzblöcke 28 verbreitert, so dass sich insgesamt ein konstanter Wellenwiderstand über die gesamte koplanare Leiterstruktur 10 vom koaxialkabelseitigen Ende 18 bis zum kontaktseitigen Ende ergibt. Die jeweiligen Metallisierungen der beiden Quarzblöcke 28 sind zweckmäßigerweise über eine geeignete Einbautechnik miteinander elektrisch leitend verbunden. Dadurch ergibt sich eine für beide Seiten der Quarzblöcke identische Potentialebene mit entsprechender identischer Abschirmfunktion.

Wie sich unmittelbar aus Fig. 1 ergibt, sind die Leiter 12, 14 in einem Bereich 29 zwischen den halternden Quarzblöcken 28 und dem kontaktseitigen Ende 20 frei im Raum angeordnet, so dass jeder Leiter 12, 14 individuell bezüglich der Halterung in den Quarzblöcken 28 federn kann. Wird nun das kontaktseitige Ende 20 dieser Meßspitze 100 mechanisch auf entsprechende Kontaktstellen für eine zu testende elektrische Schaltung aufgedrückt, so bedingt die Möglichkeit des freien Fedems für jeden einzelnen Leiter 12, 14 der koplanaren Leiterstruktur 10, dass jeder einzelne Leiter 12, 14 einen optimalen Kontakt zu der ihm jeweils zugeordneten Kontaktstelle hat. Ein etwaiges Verkippen der Meßspitze 100 beim mechanischen Andrücken auf die Kontaktstellen und etwaige Toleranzen sowohl bei den Leitern 12, 14 selbst als auch an den Oberflächen der Kontaktstellen werden durch das Federn der einzelnen Leiter 12, 14 ausgeglichen. Hierdurch wird bei jedem mechanischen Aufsetzen der Leiter 12, 14 auf entsprechende Kontaktstellen ein immer gleicher und definierter Kontakt hergestellt, so dass optimale Meßergebnisse mit der erfindungsgemäßen Meßspitze 100 erzielbar sind.

Die Darstellung der Meßspitze 100 mit drei Leitern 12, 14 in der Anordnung Masse-Signal-Masse bzw. g-s-g (g = ground; s = signal) ist lediglich beispielhaft. Selbstverständlich sind auch koplanare Leiterstrukturen mit nur zwei Leitern 12, 14 oder mehr als drei Leitern 12, 14 möglich, mit der Aufteilung von Signalleitern und Masse- bzw. Groundleitern in folgender Weise: g-s-g-s-g-s-g... oder g-s-g-g-s-g-g-s-g-g... oder ähnliches. Auf diese Weise sind auch zu testende elektrische Schaltungen mit einer einzigen Meßspitze kontaktierbar, welche mehrere koplanare Signalleitungen aufweisen.

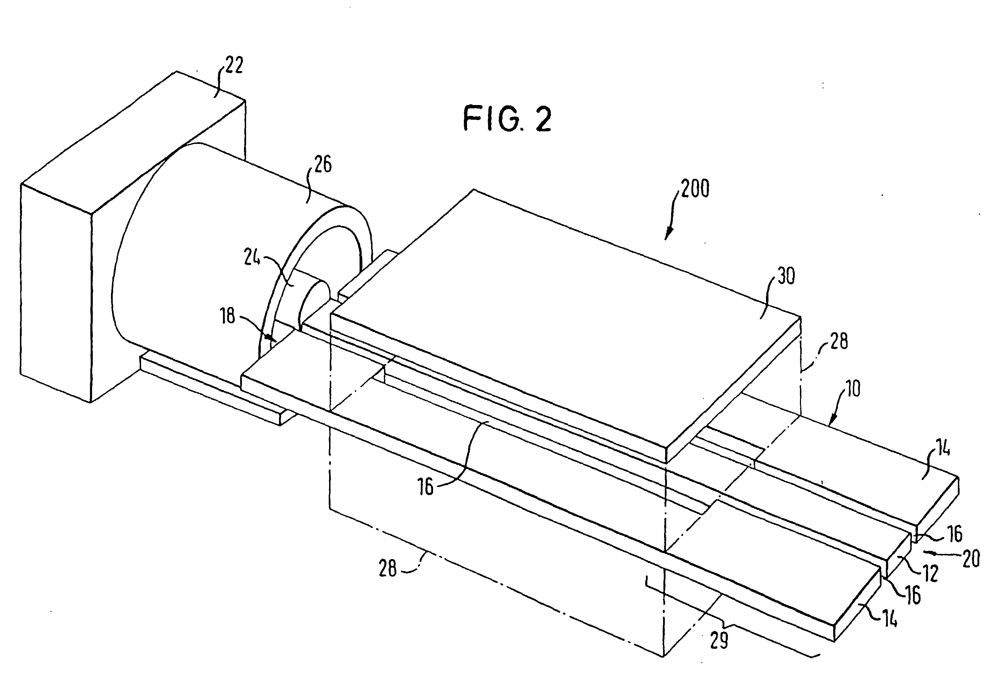

Die in Fig. 2 dargestellte zweite bevorzugte Ausführungsform einer erfindungsgemäßen Meßspitze 200 entspricht im wesentlichen derjenigen von Fig. 1, wobei gleiche Teile mit gleichen Bezugsziffern gekennzeichnet sind, so daß zu deren Beschreibung auf die obigen Erläuterungen bzgl. Fig. 1 verwiesen wird. Im Unterschied zur Ausführungsform 100 weisen die Quarzblöcke 28 an einer der koplanaren Leiterstruktur 10 abgewandten Seite eine vollflächige Metallisierung 30 auf. Diese Metallisierung führt einmal zum Unterdrücken von unerwünschten Moden höherer Ordnung abseits der gewünschten Betriebsfrequenz und schafft gleichzeitig über einen vorbestimmten Bereich der koplanaren Leiterstruktur 10 ein geschlossenes System.

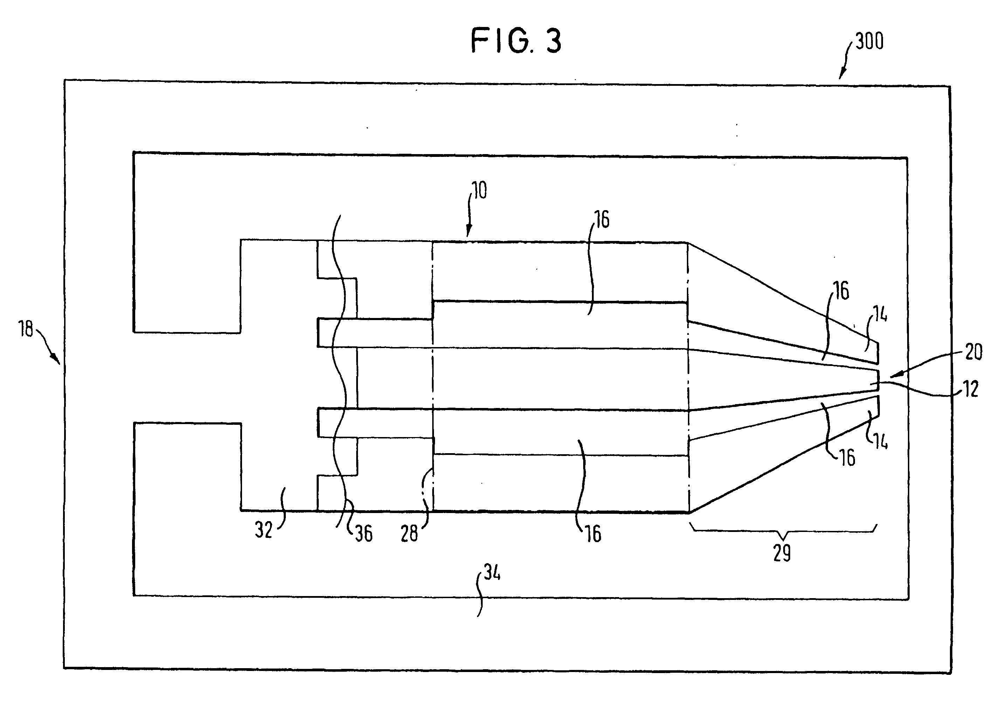

Die in Fig. 3 dargestellte dritte bevorzugte Ausführungsform einer erfindungsgemäßen Meßspitze 300 veranschaulicht den Zustand nach Herstellung der Meßspitze 300 mit einem erfindungsgemäßen Verfahren auf einen Siliziumwafer. In Fig. 3 sind wiederum gleiche Teile mit gleichen Bezugsziffern gekennzeichnet, so dass zu deren Erläuterung auf die obige Beschreibung der Fig. 1 und 2 verwiesen wird. Bei der Meßspitze 300 gemäß Fig. 3 sind die Leiter 12, 14 der koplanaren Leiterstruktur 10 zunächst nach der Herstellung mit einem nachfolgend noch näher erläuterten lithografisch-galvanoplastischen Verfahren (LiGa-Verfahren) über eine Brücke 32 miteinander mechanisch verbunden. An der Brücke 32 ist einstükkig ein Rahmen 34 ausgebildet, welcher die koplanare Leiterstruktur 10 in einer Ebene vollständig umgibt. Mittels dieses Rahmens 34 ist ein entsprechendes Handhaben der koplanaren Leiterstruktur 10 bis zur endgültigen Fertigstellung der Meßspitze möglich, ohne die Leiter 12, 14 selbst der koplanaren Leiterstruktur 10 berühren zu müssen, mit einer entsprechenden Gefahr einer Beschädigung dieser Leiter 12, 14. Nach dem Ausbilden der in Fig. 3 abgebildeten koplanaren Leiterstruktur 10 mit Brücke 32 und Rahmen 34 auf einem Siliziumwafer mit dem lithografisch-galvanoplastischen Verfahren wird diese Anordnung 10, 32, 34 von dem Siliziumwafer abgenommen, und es werden oben und unten in dem entsprechenden Bereich des verbreiterten Spaltes 16 die Quarzblöcke 28 beispielsweise mittels Bonden an der koplanaren Leiterstruktur 10 befestigt. Von nun an hat die koplanare Leiterstruktur 10 durch die Halterung mittels der Quarzblöcke 28 eine Eigenstabilität, so dass die Verbindung zwischen der koplanaren Leiterstruktur 10 und der Brücke 32 mit Rahmen 34 getrennt werden kann. Dies erfolgt beispielsweise im Bereich einer schematisch dargestellten Linie 36. Zweckmäßigerweise erfolgt die Abtrennung zwischen der Brücke 32 und der koplanaren Leiterstruktur 10 derart, dass äußere Enden 38 der beiden äußeren Masseleiter 14 am koaxialkabelseitigen Ende 18 überstehen, so dass sich eine automatische Zentrierung eines mit der koplanaren Leiterstruktur 10 zu verbindenden Koaxialkabels ergibt.

Am kontaktseitigen Ende 20 verjüngen sich die Leiter 12, 14 der koplanaren Leiterstruktur 10 zum Ausbilden einer Anordnung der Leiter 12, 14, welche entsprechend zu kontaktierenden Kontaktstellen einer zu testenden elektrischen Schaltung entspricht. Zum Aufrechterhalten eines konstanten Wellenwiderstandes verjüngt sich im Bereich 29 am kontaktseitigen Ende 20 der Spalt 16 dementsprechend in Richtung kontaktseitiges Ende 20.

Eine besonders herausragende Eigenschaft der erfindungsgemäßen Meßspitze gemäß der Fig. 1 bis 3 liegt darin, dass die mittels der Spalte 16 eingestellte Impedanz über die koplanare Leiterstruktur 10 hinweg im wesentlichen dispersionsfrei ist, d.h. die Impedanz und die Phasengeschwindigkeit sind im wesentlichen nicht abhängig von der Betriebsfrequenz.

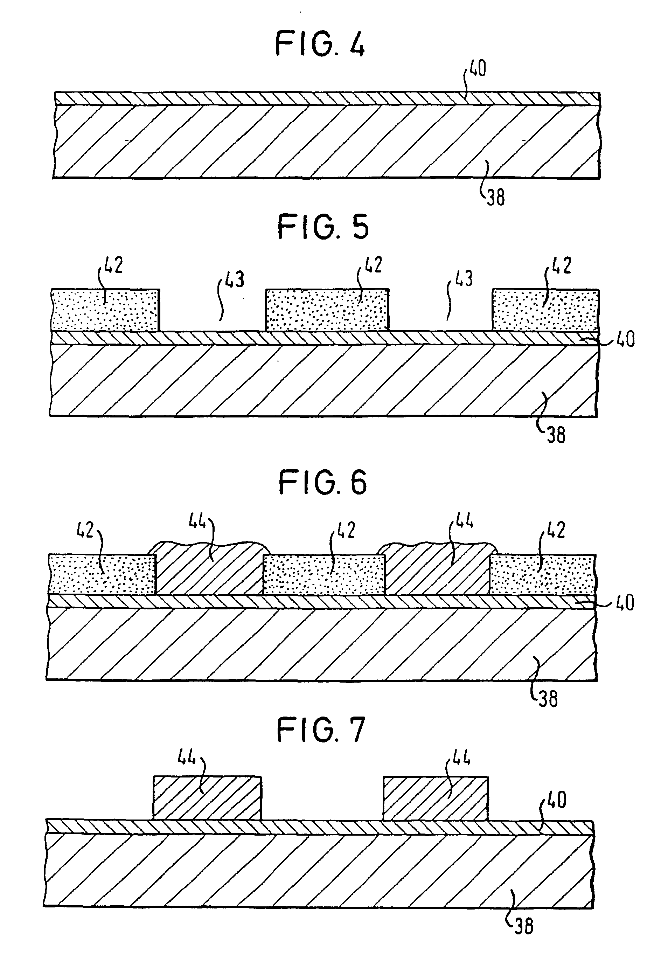

Nachfolgend wird anhand der Fig. 4 bis 7 das erfindungsgemäße Verfahren zum Herstellen einer erfindungsgemäßen Meßspitze schematisch näher erläutert. In einem ersten Schritt wird ein Siliziumwafer 38 mit einer Metallschicht 40 bedampft (Fig. 4). Die Metallschicht 40 umfaßt beispielsweise Titan, Silber, Chrom oder Gold. In einem weiteren Schritt wird, wie aus Fig. 5 ersichtlich, ein lichtempfindlicher Lack 42 auf die Metallschicht 40 aufgebracht. Dieser lichtempfindlich Lack wird durch eine Maske belichtet. Die Maske ist dabei derart ausgebildet, dass sie einer bestimmten Anzahl auf dem Siliziumwafer 38 herzustellender koplanarer Leiterstrukturen 10 mit jeweiliger Brücke 32 und jeweiligem Rahmen 34 entspricht, wie in Fig. 3 dargestellt. Ggf. sind benachbarte Rahmen mechanisch miteinander verbunden. Hierbei ist es besonders zweckmäßig, auf dem Siliziumwafer nebenund übereinander liegend viele koplanare Leiterstrukturen 10 mit Brücke 32 und Rahmen 34 gemäß Fig. 3 herzustellen. Es wird somit mittels eines fotolithographischen Verfahrens der Lack 42 in eine Form gebracht, welche einem Negativ der herzustellenden koplanaren Leiterstrukturen 10 mit jeweiligen Brücken 32 und jeweiligen Rahmen 34 entspricht. Hierbei wird der Lack in entsprechender Weise entwickelt. In einem nachfolgenden Schritt werden die in dem Lack gemäß Fig. 5 hergestellten Vertiefungen 43 mit einem elektrisch leitenden Werkstoff 44, wie beispielsweise Nickel, galvanisch aufgefüllt, wie aus Fig. 6 ersichtlich. Diese Anordnung gemäß Fig. 6 wird geschaffen, und der Lack 42 wird entfernt, so dass sich eine Anordnung gemäß Fig. 7 ergibt. Hierbei bildet nun der elektrisch leitende Werkstoff 44 die gewünschte Struktur der koplanaren Leiterstruktur 10 zusammen mit einer jeweiligen Brücke 32 und einem jeweiligen Rahmen 34, wie in Fig. 3 dargestellt, aus. Abschließend wird die Metallschicht 40, welche als Trennschicht zwischen dem elektrisch leitenden Werkstoff 44 und dem Siliziumwafer 38 wirkt, entfemt, und die Anordnung aus über- und nebeneinander liegenden koplanaren Leiterstrukturen mit Brücken und Rahmen kann vom Siliziumwafer. 38 abgenommen werden. Als nächstes wird jede einzelne koplanare Leiterstruktur 10 innerhalb eines Rahmens 34 beidseitig im entsprechenden Bereich mit den Quarzblöcken 28 versehen und schließlich die Brücken 32 mit Rahmen 34 von den koplanaren Leiterstrukturen 10 abgetrennt. Abschließend wird die koplanare Leiterstruktur 10 am koaxialkabelseitigen Ende 18 mit einem Koaxialkabel verbunden.

Besonders bemerkenswert bei dem erfindungsgemäßen Verfahren ist, dass die einzelnen Leiter 12, 14 der koplanaren Leiterstruktur 10 in keiner Weise bei der Montage zueinander ausgerichtet werden müssen. Die relative Anordnung der Leiter 12, 14 zueinander ist vom Anfang bis zum Ende des Herstellungsprozesses vorgegeben und fest. Dadurch entfallen etwaige Toleranzen beim mechanischen Anordnen der Einzelleiter 12, 14 beim Herstellungsverfahren

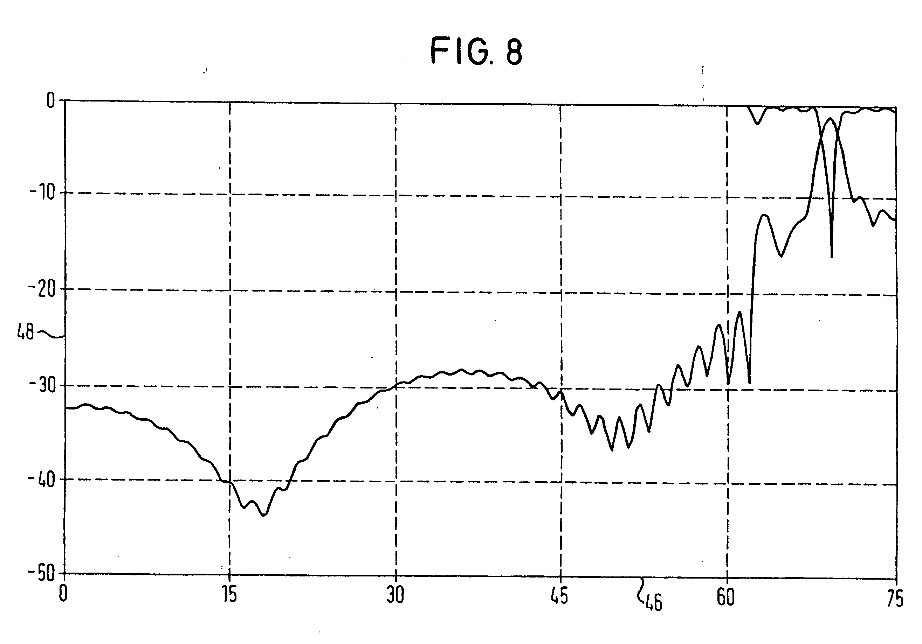

Die erfindungsgemäße Meßspitze weist, wie aus Fig. 8 ersichtlich, ein überraschend gutes Frequenzverhalten auf. Fig. 8 veranschaulicht einen S-Parameterplott aus einer Simulationsrechnung für eine erfindungsgemäße Meßspitze. Hierbei ist auf der horizontalen Achse 46 eine Frequenz in GHz und auf der vertikalen Achse 48 ein S-Parameter in dB aufgetragen. Wie sich unmittelbar aus der Graphik gemäß Fig. 8 ergibt, ist die erfindungsgemäße Meßspitze gemäß dieser Modellrechnung bis zu Frequenzen von 60 GHz brauchbar. Dies bei gleichzeitiger Möglichkeit der Serienfertigung mit geringem Ausschuß und geringem Aufwand.

## Patentansprüche

1. Meßspitze (100, 200, 300) zur Hochfrequenzmessung mit einem kontaktseitigen Ende (20) zum Kontaktieren von planaren Strukturen und einem koaxialkabelseitigen Ende (18) zum Verbinden mit einem Koaxialkabel (22), wobei zwischen dem kontaktseitigen Ende (20) und dem koaxialkabelseitigen Ende (18) eine koplanare Leiterstruktur (10) mit wenigstens zwei Leitern (12, 14) angeordnet ist, wobei auf der koplanaren Leiterstruktur (10) ein die koplanare Leiterstruktur (10) halterndes Dielektrikum (28) angeordnet ist,
**dadurch gekennzeichnet,**
**daß** das Dielektrikum (28) auf der koplanaren Leiterstruktur (10) in einem mittleren Abschnitt zwischen und in Ausbreitungsrichtung beabstandet von dem koaxialkabelseitigen Ende (19) und dem kontaktseitigen Ende (20) wenigstens einseitig, insbesondere beidseitig, derart angeordnet ist, daß zwischen dem Dielektrikum (28) und dem kontaktseitigen Ende (20) jeder Leiter (12, 14) der koplanaren Leiterstruktur (10) individuell frei im Raum und bzgl. des halternden Dielektrikums (28) federnd ausgebildet ist, wobei zwischen je zwei Leitern (12, 14) der koplanaren Leiterstruktur (10) von dem koaxialkabelseitigen Ende (18) bis zum kontaktseitigen Ende (20) ein jeweiliger Spalt (16) derart ausgebildet ist, daß sich vom koaxialkabelseitigen Ende (18) bis zum kontaktseitigen Ende (20) ein konstanter Wellenwiderstand ergibt.

2. Meßspitze (100, 200, 300) nach Anspruch 1, **dadurch gekennzeichnet, daß** der jeweilige Spalt (16) im Bereich des Dielektrikums (28) breiter ausgebildet ist als in Bereich der koplanaren Leiterstruktur (10) ohne Dielektrikum (28).

3. Meßspitze (100, 200, 300) nach einem der Ansprüche 1 oder 2, **dadurch gekennzeichnet, daß** das Dielektrikum als wenigstens ein Quarzblock (28) ausgebildet ist.

4. Meßspitze (100, 200, 300) nach wenigstens einem der vorhergehenden Ansprüche, **dadurch gekennzeichnet, daß** das Dielektrikum (28) an einer Verbindungsseite mit der koplanaren Leiterstruktur (10) eine sich mit letzterer im wesentlichen deckende Metallbeschichtung aufweist.

5. Meßspitze (200) nach wenigstens einem der vorhergehenden Ansprüche, **dadurch gekennzeichnet, daß** das Dielektrikum (28) an einer der koplanaren Leiterstruktur abgewandten Seite vollflächig metallisiert ist.

6. Meßspitze nach wenigstens einem der vorhergehenden Ansprüche, **dadurch gekennzeichnet, daß** am koaxialkabelseitigen Ende (18) eine planare Schaltung, insbesondere eine elektrische, elektronische bzw. aktive Schaltung, oder wenigstens ein aktives Schaltungselement, angeordnet ist.

## Claims

1. Measuring probe (100, 200, 300) for measuring high Frequencies, having a contact end (20) for contacting planar structures and a co-axial cable end (18) for connection to a coaxial cable (22), a co-planar conductor structure (10) having at least two conductors (12, 14) being arranged between the contact end (20) and the co-axial cable end (18) and a dielectric (28) acting as a mounting for the co-planar conductor structure (10) being arranged on the co-planar conductor structure (10), **characterised in that** the dielectric (28) is arranged on at least one side, and in particular on both sides, of the co-planar conductor structure (10) in a central section between, and spaced away from in the direction of propagation, the coaxial cable end (19) and the contact end (20), in such a way that each conductor (12, 14) in the co-planar conductor structure (10) is formed to be individually free in space and resilient in relation to the dielectric (28) acting as its mounting, a respective gap (16) being formed between each pair of conductors (12, 14) in the co-planar conductor structure (10) from the co-axial cable end (18) to the contact end (20) in such a way that a constant characteristic impedance is obtained from the co-axial cable end (18) to the contact end (20).

2. Measuring probe (100, 200, 300) according to claim 1, **characterised in that** the respective gap (16) is made wider in the region of the dielectric (28) than in the region of the coplanar conductor structure (10) where there is no dielectric (28).

3. Measuring probe (100, 200, 300) according to either of claims 1 and 2, **characterised in that** the dielectric is in the form of at least one block of quartz (28).

4. Measuring probe (100, 200, 300) according to at least one of the foregoing claims, **characterised in that** the dielectric (28) has, on a side where it is connected to the co-planar conductor structure (10), a metal coating which substantially coincides in shape with the latter.

5. Measuring probe (200) according to at least one of the foregoing claims, **characterised in that** the dielectric (28) is metallised over its full area on a side remote from the co-planar conductor structure.

6. Measuring probe according to at least one of the foregoing claims, **characterised in that** a planar circuit and in particular an electrical or electronic, i.e. active, circuit or at least one active circuit element is arranged at the co-axial cable end (18).

## Revendications

1. Pointe de mesure (100, 200, 300) pour la mesure à haute fréquence, comprenant une extrémité (20) côté contact pour la mise en contact de structures planaires, et une extrémité (18) côté câble coaxial pour la jonction avec un câble coaxial (22), dans laquelle une structure conductrice coplanaire (10) comportant au moins deux conducteurs (12, 14) est agencée entre l'extrémité (20) côté contact et l'extrémité (18) côté câble coaxial, et dans laquelle un diélectrique (28) qui maintient la structure conductrice coplanaire (10) est agencé sur la structure conductrice coplanaire (10),
**caractérisée en ce que**
le diélectrique (28) est agencé sur la structure conductrice coplanaire (10) dans un tronçon médian entre l'extrémité (19) côté câble coaxial et l'extrémité (20) côté contact, avec écartement dans la direction de propagation au moins sur un côté, et en particulier sur deux côtés, de telle façon que, entre le diélectrique (28) et l'extrémité côté contact (20), chaque conducteur (12, 14) de la structure conductrice coplanaire (10) est réalisé avec effet élastique individuellement librement dans l'espace et par rapport au diélectrique (28) à maintenir, et **en ce que** qu'un intervalle respectif (16) est ménagé entre deux conducteurs respectifs (12, 14) de la structure conductrice coplanaire (10) depuis l'extrémité (18) côté câble coaxial jusqu'à l'extrémité (20) côté contact, de telle manière qu'il en résulte une impédance caractéristique constante depuis l'extrémité (18) côté câble coaxial jusqu'à l'extrémité (20) côté contact.

2. Pointe de mesure (100, 200, 300) selon la revendication 1, **caractérisée en ce que** l'intervalle respectif (16) dans la région du diélectrique (28) est réalisé plus large que dans la région de la structure conductrice coplanaire (10) sans diélectrique (28).

3. Pointe de mesure (100, 200, 300) selon l'une ou l'autre des revendications 1 et 2, **caractérisée en ce que** le diélectrique est réalisé sous forme d'au moins un bloc de quartz (28).

4. Pointe de mesure (100, 200, 300) selon l'une au moins des revendications précédentes, **caractérisée en ce que** le diélectrique (28) comporte, au niveau d'un côté de liaison avec la structure conductrice coplanaire (10), un revêtement métallique qui coïncide sensiblement avec cette dernière.

5. Pointe de mesure (200) selon l'une au moins des revendications précédentes, **caractérisée en ce que** le diélectrique (28) est métallisé sur toute sa surface sur un côté détourné de la structure conductrice coplanaire.

6. Pointe de mesure selon l'une au moins des revendications précédentes, **caractérisée en ce qu'**un circuit planaire, en particulier un circuit électrique, électronique ou actif, ou au moins un élément de circuit actif, est agencé sur l'extrémité (18) côté câble coaxial.
